# EUROPÄISCHE PATENTANMELDUNG

(11) **EP 1 978 618 A1**
(43) Veröffentlichungstag der Anmeldung: **08.10.2008**
(21) Anmeldenummer: 08102695.7
(22) Anmeldetag: 18.03.2008
(51) Int. Cl.: H02J 9/00, H05B 1/00

(54) **Elektrogerät mit verringertem Standbyverbrauch**

(30) Priorität: 03.04.2007 DE 102007016075
(71) Anmelder: BSH Bosch und Siemens Hausgeräte GmbH, 81739 München (DE)
(72) Erfinder: Beifuss, Wolfgang, 83339, Chieming (DE); Bosold, Karl-Richard, 83368, St. Georgen (DE); Has, Uwe, 84579, Unterneukirchen (DE); Maier, Thomas, 84518, Garching a.d. Alz (DE); Marbach, Andreas, 83374, Traunwalchen (DE); Schmal, Stefan, 84101, Niedersüßbach (DE); Schneider, Ralf, 83371, Stein a.d. Traun (DE); Schuhbaeck, Peter, 83329, Otting (DE); Stitzl, Bernd, 83362, Surberg (DE)

(57) **Zusammenfassung**

Unter einem Gesichtspunkt der Erfindung weist ein Elektrogerät mit einem Transformator zum Umwandeln eines Netzstrom in einen Nutzstrom für eine Steuereinheit einen Schalter zum wahlweisen Einschalten und Ausschalten eines Primärstromkreises des Transformators auf, der mittels eines berührungsempfindlichen Sensors einschaltbar ist.

## Beschreibung

Die Erfindung betrifft Elektrogeräte, insbesondere Haushaltsgeräte, und Systeme aus mehreren Elektrogeräten mit verringertem Standby-Verbrauch.

Aus DE 44 44 259 C1, DE 196 52 472 A1 und DE 195 37 600 A1 sind elektronische Schaltungen zur Energieeinsparung bei Wechselstromtransformatoren bekannt, die zur primärseitigen Trennung bzw. Schließung eines Transformators einen elektronischen Schalter aufweisen. Das in diesen Druckschriften offenbarte Schaltungsprinzip ist als sog. Horstmann-Schaltung bekannt. Der elektronische Schalter kann beispilsweise mittels einer Schaltleitung, z. B. einer Klingel oder einer Niedrigvoltstromleitung, geschaltet werden.

DE 199 32 453 und WO 01/05132 A1 offenbaren ein Elektrogerät mit Transformatornetzteil, das nach dem Horstmann-Prizip arbeitet, bei dem zur Schaltung des elektronischen Schalters zum Trennen oder Schließen eines Primärstromkreises ein von einer Datenleitung geliefertes Rufsignal verwendet wird. Hierbei ist nachteilig, dass zur Betätigung des elektronischen Schalters zum Aufwecken des Elektrogeräts aus einem Standbyzustand in einen Normalbetriebszustand ein Netzwerkanschluss vorhanden sein muss.

Beispielsweise aus DE 103 39 410 A1 ist eine Schaltungsanordnung für ein Elektrogerät nach dem Horstmann-Prinzip bekannt, bei dem eine am Netz hängende Schaltungseinrichtung, z. B. ein Komparator, Signale von einem Mikrofon aufnimmt und aufbereitet und dann an einen elektronischen Schalter zur wahlweisen primärseitigen Trennung eines Netzteils von einem Stromversorgungsanschluss nach dem Horstmann-Prinzip weiterleitet. Alternativ zu akustischen können auch optische oder dergleichen Signale der Schaltungseinrichtung zugeführt werden. Dabei ist z. B. nachteilig, dass das Gerät vergleichsweise einfach unabsichtlich betätigt werden kann.

Ein Stromschaltung mittels extern bewegter Magnete, die einen Magnetsensor oder Magnetschalter, insbesondere Reed-Schalter, betätigen, ist beispielsweise aus US 4,317,016, US 3,711,672, US 3,852,558, DE 199 23 148 A1, DE 199 44 235 A1, EP 0 497 191 A1 , EP 0 260 091 A2WO 89/04543 oder DE 100 63 693 C1 bekannt.

Es ist die Aufgabe der vorliegenden Erfindung, eine vergleichsweise einfache, fehlerrobuste, autarke und effiziente Möglichkeit zur Verringerung des StandbyBetriebs von Elektrogeräten zu schaffen.

Diese Aufgabe wird durch die Gegenstände der Ansprüche 1, 2, 3, 6 und / oder 9 gelöst. Vorteilhafte Ausgestaltungen sind insbesondere den Unteransprüchen entnehmbar.

Die Lösung der Aufgabe beruht auf der Erkenntnis, dass sich ein Stromverbrauch im Standbybetrieb unter anderem verringern lässt durch (I) Verwenden eines gemeinsamen Hauptschalters für mehrere Elektrogeräte und / oder (II) durch Verwenden eines Stromspeichers zum Ein- und Ausschalten eines Elektrogeräts und / oder (III) durch Ein- und Ausschalten eines Elektrogeräts mittels eines primärseitigen Schalters mit (A) geringem bis (B) keinem Ruhestrom.

Die Aufgabe wird gelöst durch ein Elektrogerät, insbesondere Haushaltsgerät, mit einem EIN/AUS-Schalter, insbesondere einem Hauptschalter, zum wahlweisen Einschalten und Ausschalten des Haushaltsgeräts, wobei der EIN/AUS-Schalter für mindestens ein weiteres Haushaltsgerät nutzbar ist.

Die Aufgabe wird auch gelöst durch ein Elektrogerät, insbesondere Haushaltsgerät, insbesondere nach auch nach der obigen Art, mit einem Transformator zum Umwandeln eines Netzstrom in einen Nutzstrom für das Haushaltsgerät, wobei der Transformator als ein Transformator zum Umwandeln eines Netzstroms in einen Nutzstrom für mindestens ein weiteres Haushaltsgerät nutzbar ist.

Die Aufgabe wird auch gelöst durch ein System aus mehreren Elektrogeräten, insbesondere Haushaltsgeräten, wobei es mindestens eines der obigen Haushaltsgeräte umfasst.

Vorteilhafterweise ist dabei der Hauptschalter und / oder der Transformator bezüglich der mehreren Elektrogeräte extern angeordnet.

Vorteilhafterweise sind die mehreren Elektrogeräte mittels eines gemeinsamen Hauptschalters gemeinsam wahlweise einschaltbar und ausschaltbar und / oder mittels eines gemeinsamen Transformators zum Umwandeln des Netzstrom in den Nutzstrom für eine jeweilige Steuereinheit gemeinsam mit Strom versorgbar.

Die Aufgabe wird auch gelöst durch ein Elektrogerät, insbesondere Haushaltsgerät, das einen Stromspeicher zur Versorgung mindestens einer Gerätesteuerungskomponente mit Strom im Standbybetrieb aufweist. Vorzugsweise ist derselbe oder ein weiterer Stromspeicher zum Betreiben eines EIN-Schalters zum Schließen des Primärstromkreises vorgesehen.

Das Elektrogerät ist vorteilhafterweise dazu eingerichtet ist, den Stromspeicher im normalen Betrieb aufzuladen.

Der Stromspeicher ist vorteilhafterweise ein 'Gold-Cap'-Akkumulator.

Die Aufgabe wird auch gelöst durch ein Elektrogerät, insbesondere Haushaltsgerät, mit einem Transformator zum Umwandeln eines Netzstrom in einen Nutzstrom und einem Schalter zum wahlweisen Einschalten und Ausschalten eines Primärstromkreises des Transformators, wobei der Schalter mittels eines berührungsempfindlichen Sensors einschaltbar ist.

Vorteilhafterweise ist der Schalter ein elektronischer Schalter, insbesondere ein Diac.

Vorteilhafterweise ist der elektronische Schalter ein Teil einer Horstmann-Schaltung.

Vorteilhafterweise ist der Schalter ein durch Stromzufuhr betätigbarer mechanischer Schalter.

Vorteilhafterweise ist eine Stromzufuhr zum mechanischen Schalter mittels eines elektronischen Schalters wahlweise einschaltbar und ausschaltbar.

Vorteilhafterweise weist das Elektrogerät ferner einen Stromspeicher zum Zuführen von Strom zum mechanischen Schalter auf, wobei der elektronische Schalter die Stromzufuhr vom Stromspeicher zum mechanischen Schalter wahlweise einschaltet und ausschaltet.

Vorteilhafterweise ist der berührungsempfindliche Sensor ein piezoelektrischer Sensor, ein magnetischer Sensor, ein kapazitiver Sensor und / oder ein GMR-Sensor.

Das Elektrogerät weist vorteilhafterweise einen Stromspeicher und eine den Stromspeicher netzunabhängig aufladende Stromquelle auf.

Vorzugsweise weist die den Stromspeicher netzunabhängig aufladende Stromquelle eine Solarzelle auf.

Vorzugsweise weist das Elektrogerät einen mechanisch betätigbaren Notschalter auf, durch dessen Betätigung der Primärkreis des Haushaltsgeräts geschlossen wird.

Die Erfindung wird in den folgenden Figuren anhand von Ausführungsbeispielen schematisch genauer beschrieben. Dabei werden, wo sinnvoll, gleiche oder gleichwirkende Elemente mit gleichen Bezugsziffern bezeichnet. Die Ausführungsbeispiele sind nicht dazu gedacht, die Erfindung zu beschränken.
- FIG 1: zeigt skizzenartig eine Aufsicht auf eine Ausführungsform eines Herds;
- FIG 2: zeigt skizzenartig eine Aufsicht auf eine weiterere Ausführungsform eines Herds;
- FIG 3: zeigt einen Querschnitt durch eine Arbeitsumgebung einer Küche;
- FIG 4: zeigt skizzenhaft eine Schaltungsanordnung eines Haushaltsgeräts mit verringerten Standbyverbrauch;
- FIG 5: zeigt skizzenhaft eine weitere Schaltungsanordnung eines Haushaltsgeräts mit verringerten Standbyverbrauch;
- FIG 6: zeigt skizzenhaft noch eine weitere Schaltungsanordnung eines Haushaltsgeräts mit verringerten Standbyverbrauch;
- FIG 7: zeigt im Querschnitt in den Teilbildern 7A- bis 7C Aufbau und Zustände eines magnetischen berührungsempfindlichen Sensors.

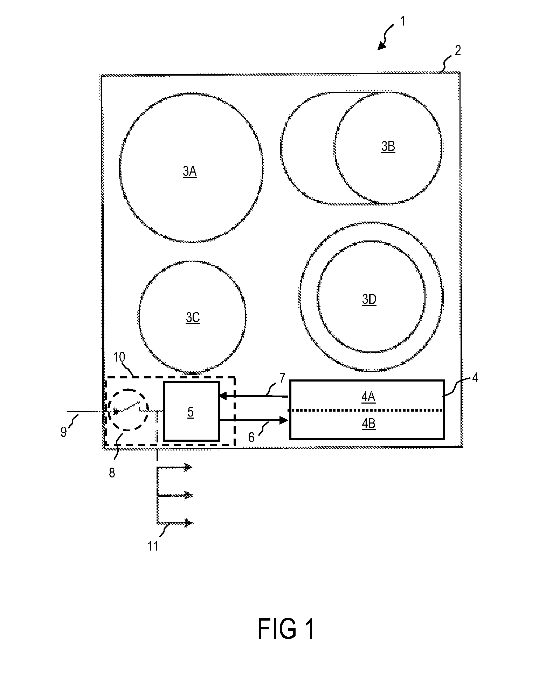

FIG 1 zeigt einen Herd 1 mit einem Kochfeld 2 mit einer Oberfläche aus Glaskeramik, das verschiedene Kochstellen 3A - 3D aufweist. Der Herd 1 weist zur eine Steuereinheit 4 in Form einer Steuerelektronik auf, die eine Gerätesteuerung 4A zum Betrieb der Kochstellen 3A - 3D und eine Touchcontrol-Hauptplatine 4B zur Steuerung der Dateneingabe und Datenausgabe eines (hier nicht dargestellten) Touchcontrol-Eingabe- und -anzeigefelds umfasst. Durch die Ausgestaltung der Bedienelemente als Touchcontrolelemente kann eine Bedienung des Herds 1 durch Berühren der Glaskeramikoberfläche durchgeführt werden. Touchcontrol-Bedienelemente können beispielsweise an der Unterseite der Glaskeramikoberfläche Piezosensoren oder kapazitive Sensoren aufweisen, die eine Berührung der Oberseite an der entsprechenden Stelle aufnehmen und an die Touchcontrol-Hauptplatine 4B weiterleiten. Die daraus mittels der Touchcontrol-Hauptplatine 4B erzeugten digitalen Bediendaten werden dann von der Gerätesteuerung 4A in Steuersignale für die Kochstellen 3A-3D umgesetzt. Die Steuereinheit 4 wird von einem Netzteil 5 mit Leistung versorgt, wie für durch den Pfeil 6 angedeutet. Die Steuereinheit 4 kann aber auch das Netzteil 5 steuern, z. B. das Netzteil 5 in einen Standbybetrieb umschalten, wie durch den Pfeil 7 angedeutet. Das Netzteil 5 kann primärseitig durch einen EIN/AUS-Schalter 8 von einem Netzanschluss 9 getrennt werden. Das Netzteil 5 und der EIN/AUS-Schalter 8 können auch als gemeinsames Netzgerät 10 ausgeführt sein, wie durch das gestrichelte Rechteck angedeutet. Der EIN/AUS-Schalter 8 ist vorzugsweise ein mechanischer Hauptschalter, der insbesondere mittels einer Druck-, Zug, Schub- oder Drehbewegung betätigt wird.

In diesem Ausführungsbeispiel schaltet der EIN/AUS-Schalter 8 des Herds 1 optional auch noch weitere Geräte (nicht dargestellt) ein bzw. aus, wie durch den mindestens einen Pfeil 11 angedeutet. Der Herd 1 dient somit als Haupt- oder Master-Gerät für die damit ebenfalls ein- und ausgeschalteten Neben- oder Slave-Geräte. Als ein Beispiel für ein Nebengerät (nicht dargestellt) kann eine über dem Herd 1 angeordnete Dunstabzugshaube sein. Durch die Schaltung mehrerer Haushaltsgeräte mit einem gemeinsamen EIN/AUS-Schalter wird sichergestellt, das alle zugehörigen Geräte tatsächlich primärseitig allpolig abgeschaltet sind und somit bei allen kein Standbystrom verbraucht wird. Die Nebengeräte können weiterhin einen eigenen, nachgeordneten EIN/AUS-Schalter aufweisen

In einer alternativen Ausführungsform schaltet der EIN/AUS-Schalter das Netzteil nicht ein, sondern aktiviert es nur. Das Netzteil wird von der Steuereinheit (elektronik) aktiv gehalten, und kann dann auch wieder abgeschaltet werden, wenn die Steuereinheit z. B. befindet, dass ein weiterer Betrieb des Netzteils nicht mehr notwendig ist.

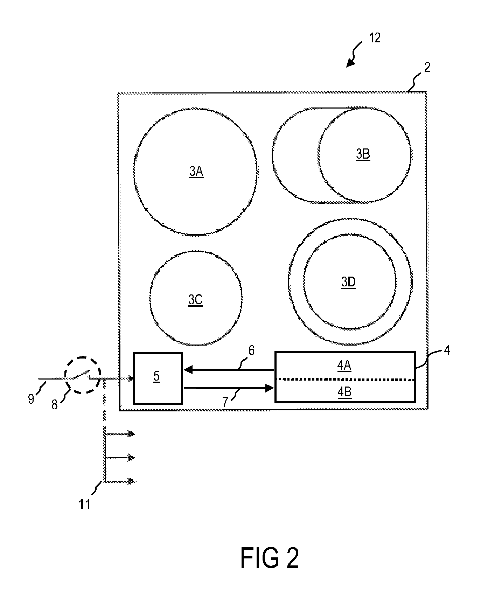

FIG 2 zeigt eine weitere Ausführungsform, bei der der Schalter 8 sich nun ausserhalb des Herds 12 befindet. Durch dieses Anordnung lässt sich der Schalter 8 flexibel positionieren, was die Bedienung und damit Abschaltung bequem ermöglicht.

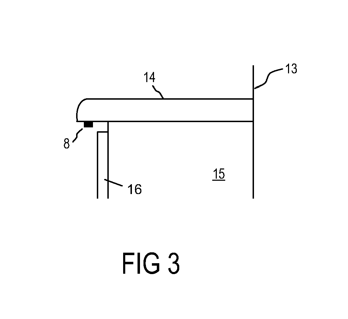

FIG 3 zeigt einen Querschnitt durch eine an einer Wand 13 befestigten Küchenarbeitsplatte 14, die auf einem Unterschrank 15 aufliegt, der frontseitig eine Tür 16 aufweist. Der Schalter 8, z. B. einer Anordnung nach FIG 2, ist unterseitig an einem frontseitigen Vorsprung der Arbeitsplatte 14 angeordnet.

In einer alternativen Ausführungsform wird eine Vielzahl von Hausgeräten durch ein gesondertes Hauptschaltgerät eingeschaltet. Dieses gesonderte Hauptschaltgerät kann ein einfaches Netzteil enthalten, welches ständig an Spannung liegt. Dadurch wird in jedem Fall in der Gesamtheit der angeschlossenen Geräte der Energiebedarf minimiert. Dies gilt auch dann, wenn im Hausgerät ein eigenes Netzteil vorhanden ist. Dabei muss das Hauptschaltgerät nicht notwendigerweise einen manuell zu bedienenden Schalter aufweisen. Der Schalter kann auch beispielsweise ein nichtmechanischer berührungsempfindlicher Sensor sein, wie ein piezoelektrischer, magnetischer oder kapazitiver Sensor. Eine andere Sensorausführung kann einen Anwesenheitssensor mit minimalem Stromverbrauch umfassen, z. B. einen Bewegungsmelder, der die angeschlossenen Geräte aktiviert, wenn sich Personen in der Nähe befinden. Ein Beispiel für einen solchen Abstandssensor ist ein Gewichtssensor im Boden vor dem Hausgerät (z. B. einer Spülmaschine, einem Herd, einem Ofen, einer Kühlshrank usw.). Dieser Schalter aktiviert die angeschlossene Steuerelektronik, wenn jemand auf diesen tritt.

Insgesamt kann es eine bevorzugte Ausführung sein, eine Kombination verschiedener EIN/AUS-Schalter in verschiedenen Geräten vorzusehen. Dabei sollte es möglich sein, durch hierarchisch hochstehende Geräte, auch niedrigerstehende Geräte auszuschalten.

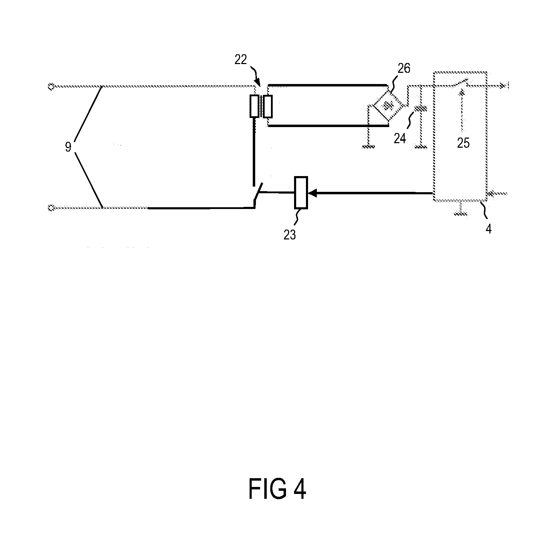

FIG 4 zeigt Komponenten eines Haushaltsgeräts in einer weiteren Ausführungsform. In dieser Ausführungsform ist in einem von einem Netzanschluss 9 gespeisten primärseitigen Stromkreis in Bezug auf einen zu aktivierenden Transformator 22 ein EIN/AUS-Schalter 23, z. B. ein Relais, eingebracht, der den primären Stromkreis, vorzugsweise allpolig, öffnen und schliessen kann. Der EIN/AUS-Schalter 23 wird von einer elektrisch-elektronischen Steuereinheit 4 geschaltet. Damit eine Steuereinheit 4 nach Öffnen des EIN/AUS-Schalters 22, wodurch das Netzteil 22 auch sekundärseitig keinen Strom mehr liefern kann, in der Lage ist, den EIN/AUS-Schalter 23 zu betätigen, ist ein Stromspeicher 24 in Form eines sog. 'Gold Cap'-Akkumulators vorgesehen, der im Standbymodus die sekundärseitige Steuerelektronik 4 und -elektrik speist. Gleichzeitig muss auch genügend Leistung zum Betätigen des EIN/AUS-Schalters 23 vorgesehen werden. Wird also der EIN/AUS-Schalter 23 zum Abschalten des Haushaltsgeräts geöffnet, so versorgt, abhängig von seiner Dimensionierung, der Akkumulator 24 die Steuerelektronik 4, oder einen Teil davon. Wird dort am Bedienfeld eine Einschalttaste 25 betätigt, veranlasst die Steuerelektronik 4 ein Schliessen des EIN/AUS-Schalters 23, wodurch die Steuerelektronik 4 wieder, über einen Gleichrichter 26, mit Strom vom Transformator 22 versorgt wird. Dabei wird gleichzeitig der Akkumulator 24 wieder aufgeladen. Es können auch mehrere Akkumulatoren vorgesehen sein.

Für den Fall, dass nach einer längeren Standzeit der Stromspeicher 24 verbraucht sein sollte, ist es möglich, den Schalter 23 - oder z. B. einen dazu parallel geschalteten Schalter (nicht dargestellt) - im Notfallbetrieb mechanisch zu schließen, z. B. durch Betätigen eines seitlich angebrachten mechanischen Druckschalters (nicht dargestellt) für mehrere Sekunden, oder eines mechanischen Druckschalters (nicht dargestellt), der durch Einführen eines längliches Gegenstands in eine Geräteöffnung betätigt werden kann.

Im normalen Betrieb wird durch die Steuereinheit 4 Leistung für die Kochstellen freigegeben, wie durch den oberen rechten Pfeil angedeutet, wobei die Leistung durch einen Mikroprozessor eingestellt wird, wie durch den gepunkteten Pfeil 25 angedeutet. In die Steuereinheit 4 gehen Informationen von peripherer Elektronik ein, ob noch Leistung benötigt wird, wie durch den rechten unteren Pfeil angedeutet.

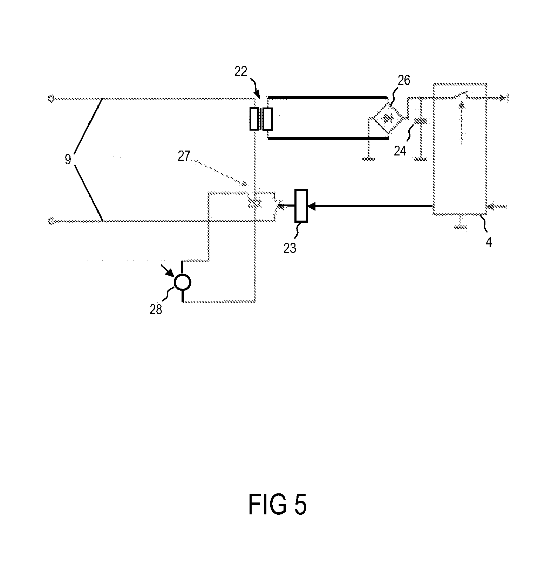

FIG 5 zeigt elektrische und elektronische Komponenten eines Haushaltsgeräts in noch einer weiteren Ausführungsform unter Verwendung des sog. "Horstmann"-Prinzips. Hierbei wird der primäre Stromkreis eines Transformators 22 mittels eines primären Schaltelements in Form eines elektronischen Schalters, z. B. nach Art eines Diacs 27, geöffnet bzw. geschlossen. Der Diac 27 schliesst, wenn an seinen Steuereingang ein elektrisches Steuersignal angelegt wird. In dem gezeigten Ausführungsbeispiel ist der Steuereingang des Diac 27 mit einem Signalausgang eines Sensors 28 verbunden. Der Sensor 28 ist ein Teil eines Einschalters zum Aufwecken des Haushaltsgeräts aus dem Standbybetrieb in den Normalbetrieb. Der Diac 27 ist wahlweise durch ein parallel damit verbundenes sekundäres Schaltelement in Form eines Schalters 23, z. B. nach Art eines Relais, überbrückbar. Der Schalter 23 wird analog zu dem Ausführungsbeispiel in FIG 5 durch die sekundärseitig angeordnete Steuereinheit 4 gesteuert. Es ist alternativ auch möglich, das primäre und das sekundäre Schaltelement 23, 27 zu einem einzigen Schaltelement zusammenzufassen.

Im Standbymodus sind der Schalter 23 und der Diac 27 zunächst geöffnet. Durch Betätigen des Sensors 28 sendet dieser ein elektrisches Sensorsignal an den Diac 27, das ausreicht, den Diac 27 für eine bestimmte, kurze Zeit zu öffnen. Dadurch wird der primäre Stromkreis geschlossen, wodurch wiederum die Steuereinheit 4 durch die Aktivierung des Transformators 22 sekundärseitig für etwa die gleiche Zeitdauer Strom ziehen kann. Sobald sekundärseitig Strom zur Verfügung steht, schaltet die Steuereinheit 4 den Schalter 23, so dass der primäre Stromkreis auch unabhängig vom Diac 27 und z. B. für die Dauer des Normalbetriebs geschlossen wird. Die Steuereinheit 4 öffnet den Schalter 23 typischerweise erst wieder, nachdem ein Nutzer das Gerät in den Standbymodus 'ausschaltet'.

Der Sensor 28 kann beispielsweise ein berührungs- oder näherungsempfindlicher Sensor eines Touchcontrol-Bedienfelds einer Glaskeramikplatte eines Herds, z. B. nach FIG 1, sein, der einer entsprechenden EIN-Taste zugeordnet ist. Ein solcher Sensor 28 kann ein piezoelektrischer oder kapazitiver Sensor sein, oder beispielsweise ein magnetischer Sensor nach dem Reed-Prinzip, wie er in FIG 8 dargestellt ist. Andere Sensorarten können beispielsweise Reflexlichtschranken, GMR-Sensoren (z. B. durch aufgesetzte Magnete, oder ohne), OFW-Sensoren, thermoelektrische Elemente wie Peltierelemente, thermochemische Sensoren, die beispielsweise ein elektrisches Signal nach Kontakt mit Hautschweis ausgeben, oder andere geeignete Sensoren umfassen. Dieser Sensor 28 kann, je nach Auslegung der Komponenten über eine Touchcontrol-Steuerplatine geschaltet werden, oder nicht. Dies hängt beispielweise auch von der Art der Stromversorgung ab, z. B. vom Vorhandensein von Akkumulatoren 24 an der Touchcontrol-Steuerplatine und / oder dem Sensor 28. Eine weitere Möglichkeit zum Schalten liegt in der Verwendung eines Reedrelais.

In dem Ausführungsbeispiele von FIG 5 ist optional noch ein Stromspeicher 26, z. B. ein Gold-Cap, in analoger Betriebsweise wie für FIG 4 beschrieben vorgesehen; dadurch braucht der Diac 27 nicht so lange offengehalten zu werden, und zum Aufwecken des Haushaltsgeräts genügt ein schwächeres Sensorsignal. Die hier gezeigte Schaltungsvariante kann mit den obigen Ausführungsbeispielen nach den FIG 1 bis 3 kombiniert werden.

Alternativ können beispielsweise ausser einem Netzteil nach dem Horstmann-Prinzip auch Schaltnetzteile oder Kondensatornetzteile oder andere geeignete Netzteile verwendet werden.

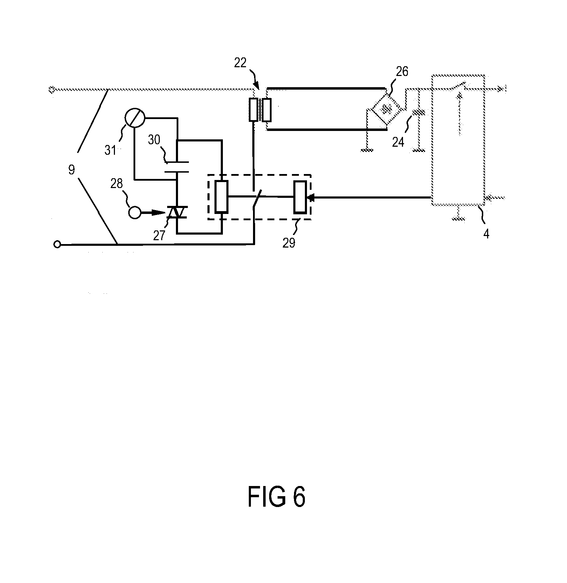

FIG 6 zeigt eine weitere Ausführungsform einer Schaltanordnung für ein Haushaltsgerät mit verringertem Standbyverbrauch. In dieser Ausführungsform wird der Primärstromkreis des Transformators 22 nur durch einen Schalter 29 geöffnet oder geschlossen, welcher den Transformator 22, vorzugsweise allpolig, vom Netz trennt. Der Schalter 29 in dieser Ausführungsform ist ein Schalter, der einerseits durch die Steuereinheit 4 langfristig geschaltet werden kann und andererseits durch eine kurzfristige Betätigung geschlossen werden kann. Die kurzfristige Betätigung kann beispielsweise durch Betätigung eines Sensors 28 ausgelöst werden.

In dem gezeigten Ausführungsbeispiel ist nach Beginn des Standbybetriebs der Schalter 29 geöffnet und trennt dadurch den Transformator 25 primärseitig allpolig vom Netz. Der Schalter 29 kann beispielsweise ein mechanischer Schalter sein, der zum Übergang vom Normalbetrieb in den Standbybetrieb durch die Steuerschaltung 4 aufgezogen worden ist, wobei die dazu notwendige Energie zum Beispiel vom Akkumulator 24 geliefert werden kann. Nach Übergang in den Standbybetrieb wird durch Betätigen des Sensors 28, z. B. eines Piezosensors, ein Diac 27 betätigt, der wiederum in Reihe mit einem Stromspeicher in Form eines Akkumulators 30 und dem Schalter 29 verbunden ist. Durch Schliessen des Diacs 27 arbeitet der Akkumulator 30 als Stromquelle für den Schalter 29, der durch die folgende Aktivierung schliesst. Durch Schließen des Schalters 29 wiederum wird der Primärstromkreis geschlossen, wodurch der Standbybetrieb in einen Normalbetrieb übergeht.

Der Schalter 29 kann beispielsweise ein elektromagnetisch ausgelöster mechanischer Schalter sein, auf den zum Öffnen eine vergleichsweise große Kraft bzw. viel Energie aufgebracht werden muss und auf den zum Schließen nur eine vergleichsweise geringe Energie aufgebracht zu werden braucht. Beispielsweise kann der Schalter 29 so ausgestaltet sein, dass beim Öffnen eine Spannkraft überwunden werden muss, die den Schalter 29 in Schließrichtung vorspannt, so dass zum Schließen nur noch eine geringe Betätigungskraft zum Freigeben der Spannkraft überwunden werden muss. Ist die zum Schließen des Schalters 29 benötigte Kraft bzw. Energie gering, so kann der Akkumulator 30 entsprechend klein dimensioniert sein oder sogar wegfallen.

Beim Vorhandensein eines Akkumulators 30 kann dieser allgemein optional in einem aufgeladenen Zustand gehalten werden, indem eine netzunabhängige (autarke) Stromquelle 31 dazu parallel angeordnet ist. Diese autarke Stromquelle 31 ist optional. Sie kann beispielsweise eine Solarzelle oder einen Knacksensor umfassen. Optional kann diese oder eine andere Stromquelle auch den Akkumulator 24 speisen (nicht dargestellt).

Eine andere Ausführungsform für eine autarke Stromquelle ist ein beispielsweise unter einer Glaskeramikplatte angebrachter piezoelektrischer Slider, bei dem in einer Ausgestaltung mehrere Piezoelemente durch eine gleitende Bewegung nacheinander betätigt werden. Dadurch kann bei Betätigung ein Ladestrom für einen Stromspeicher erzeugt werden. Um dann ein Haushaltsgerät auch nach einer längeren stromlosen Standzeit einschalten zu könnene, muss der Slider, ggf. mehrfach, betätigt werden, und dann wird der dem EIN-Schalter eines Bedienfelds zugeordnete Sensor betätigt, wodurch der Primärkreis des Netzteils 22 wieder geschlossen wird.

Es sind auch andere Schalter zum Schließen des primären Stromkreises möglich, z. B. ein Reed-Schalter.

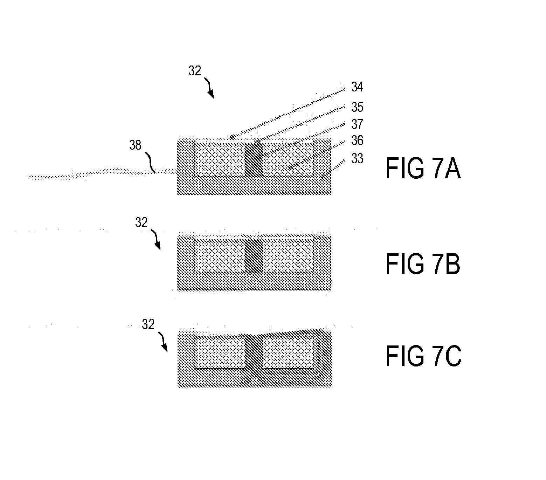

Ein Reedschalter 32 als Sensor kann nach den FIG 7A bis 7C ausgestaltet sein. Wie in FIG 7A gezeigt, weist dieser Rheedschalter 32 einen Topfkern 33 auf, der von einer Metallmembran 34 abgedeckt ist. Die Metallmembran 34 ist durch einen Luftspalt 35 von einem Spule 36 getrennt, in deren Mitte ein Permanentmagnet 37 vorhanden ist und der vom Topfkern 33 aufgenommen wird. In diesem geöffneten Zustand fliesst ein nur sehr geringer magnetischer Fluß, wie in FIG 8B angedeutet. Wie in FIG 8C gezeigt, wird durch einen äußeren Druck eine Durchbiegung der Metallmembran 34 bis zur Berührung des Permanentmagneten 37 bewirkt, wodurch der Magnetfluss sehr gross wird, was wiederum ein elektrisches Signal in der Spule induziert, das über eine Signalleitung 38 abgeführt werden kann. Ein solcher Reedsensor kann beispielsweise ein Teil eines Touchcontrolbedienfelds sein.

Die obigen Ausführungsbeispiele sind nicht dazu gedacht, die Erfindung zu beschränken. So sind die Ausführungsbeispiele auch kombinierbar. Auch sind andere Sensorarten nutzbar.

### Bezugszeichenliste

- 1: Herd
- 2: Kochfeld
- 3: Kochstelle
- 4: Steuereinheit
- 4A: Gerätesteuerung
- 4B: Touchcontrol-Hauptplatine
- 5: Netzteil
- 6: Pfeil
- 7: Pfeil
- 8: EIN/AUS-Schalter
- 9: Netzanschluss
- 10: Netzgerät
- 11: Pfeil
- 12: Herd
- 13: Wand
- 14: Arbeitsplatte
- 15: Unterschrank
- 16: Tür
- 22: Transformator
- 23: Relais
- 24: Steuereinheit
- 25: Pfeil
- 26: Stromspeicher
- 27: Diac
- 28: Sensor
- 29: Schalter
- 30: Akkumulator
- 31: netzunabhängige Stromquelle
- 32: Rheedschalter
- 33: Topfkern
- 34: Metallmembran
- 35: Luftspalt
- 36: Spule
- 37: Permanentmagnet
- 38: Signalleitung

## Patentansprüche

1. Elektrogerät, insbesondere Haushaltsgerät (1, 12), mit einem EIN/AUS-Schalter (9) zum wahlweisen primärseitigen Einschalten und Ausschalten des Haushaltsgeräts (1, 12), **dadurch gekennzeichnet, dass** der EIN/AUS-Schalter (8) als ein EIN/AUS-Schalter für mindestens ein weiteres Haushaltsgerät nutzbar ist.

2. Elektrogerät, insbesondere Haushaltsgerät, insbesondere nach Anspruch 1, mit einem Transformator (22) zum Umwandeln eines Netzstroms in einen Nutzstrom für eine Steuereinheit (4) des Haushaltsgeräts, **dadurch gekennzeichnet, dass** der Transformator (22) als ein Transformator zum Umwandeln eines Netzstrom in einen Nutzstrom für mindestens eine Steuereinheit eines weiteren Haushaltsgeräts nutzbar ist.

3. System aus mehreren Elektrogeräten, insbesondere Haushaltsgeräten, **dadurch gekennzeichnet, dass** es ein Haushaltsgerät nach einem der Ansprüche 1 oder 2 umfasst.

4. System nach Anspruch 3, **dadurch gekennzeichnet, dass** der EIN/AUS-Schalter (8) und / oder der Transformator bezüglich der mehreren Elektrogeräte extern angeordnet ist.

5. System nach Anspruch 4, **dadurch gekennzeichnet, dass** die mehreren Elektrogeräte mittels des gemeinsamen Hauptschalters (8) gemeinsam wahlweise einschaltbar und ausschaltbar sind und / oder mittels des gemeinsamen Transformators (22) gemeinsam mit Strom versorgbar sind.

6. Elektrogerät, insbesondere Haushaltsgerät, **dadurch gekennzeichnet, dass** es einen Stromspeicher (24, 30) zur Versorgung mindestens einer Gerätesteuerungskomponente mit Strom im Standbybetrieb aufweist.

7. Elektrogerät nach Anspruch 6, **dadurch gekennzeichnet, dass** es dazu eingerichtet ist, den Stromspeicher (24, 30) im normalen Betrieb aufzuladen.

8. Elektrogerät nach Anspruch 6 oder 7, **dadurch gekennzeichnet, dass** der Stromspeicher ein 'Gold-Cap'-Akkumulator ist.

9. Elektrogerät, insbesondere Haushaltsgerät, mit einem Transformator (22) zum Umwandeln eines Netzstrom in einen Nutzstrom für eine Steuereinheit (4) und einem Schalter (27, 29) zum wahlweisen Einschalten und Ausschalten eines Primärstromkreises des Transformators (22), insbesondere nach Anspruch 2, **dadurch gekennzeichnet, dass** der Schalter (27, 29) mittels eines berührungs- oder näherungsempfindlichen Sensors (28) einschaltbar ist.

10. Elektrogerät nach Anspruch 9, **dadurch gekennzeichnet, dass** der Schalter ein elektronischer Schalter ist, insbesondere ein Diac (27).

11. Elektrogerät nach Anspruch 10, **dadurch gekennzeichnet, dass** der elektronische Schalter (27) ein Teil einer Horstmann-Schaltung ist.

12. Elektrogerät nach Anspruch 9, **dadurch gekennzeichnet, dass** der Schalter ein durch Stromzufuhr betätigbarer mechanischer Schalter (29) ist.

13. Elektrogerät nach Anspruch 12, **dadurch gekennzeichnet, dass** eine Stromzufuhr zum mechanischen Schalter (29) mittels eines elektronischen Schalters (27) wahlweise einschaltbar und ausschaltbar ist.

14. Elektrogerät nach Anspruch 13, **dadurch gekennzeichnet, dass** ferner ein Stromspeicher (30) zum Zuführen von Strom zum mechanischen Schalter (29) vorhanden ist, wobei der elektronische Schalter (27) die Stromzufuhr vom Stromspeicher (30) zum mechanischen Schalter (29) wahlweise einschaltet und ausschaltet.

15. Elektrogerät nach einem der Ansprüche 9 bis 14, **dadurch gekennzeichnet, dass** der berührungs- oder näherungsempfindliche Sensor (28) ein piezoelektrischer Sensor, ein magnetischer Sensor, ein kapazitiver Sensor und / oder ein GMR-Sensor ist.

16. Elektrogerät nach einem der vorhergehenden Ansprüche, **dadurch gekennzeichnet, dass** es einen Stromspeicher (24, 30) und eine den Stromspeicher (30) netzunabhängig aufladende Stromquelle (31) aufweist.

17. Elektrogerät nach einem der vorhergehenden Ansprüche, **dadurch gekennzeichnet, dass** die netzunabhängig aufladende Stromquelle (31) eine Solarzelle aufweist.

18. Elektrogerät nach einem der vorhergehenden Ansprüche, **dadurch gekennzeichnet, dass** es einen mechanisch betätigbaren Notschalter aufweist, durch dessen Betätigung der Primärstromkreis des Elektrogeräts geschlossen wird.
